(19)

Europäisches
Patentamt
European
Patent Office
Office européen
des brevets

(11)  **EP 3 819 946 A1**

(12)  **EUROPEAN PATENT APPLICATION**

(43) Date of publication:
**12.05.2021 Bulletin 2021/19**

(51) Int Cl.:
**H01L 31/032** (2006.01)     **H01L 21/02** (2006.01)
**H01L 31/0749** (2012.01)     **H01L 31/18** (2006.01)
**H01L 31/0296** (2006.01)

(21) Application number: **19208081.0**

(22) Date of filing: **08.11.2019**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **EMPA Eidgenössische Materialprüfungs- und
Forschungsanstalt
8600 Dübendorf (CH)**
• **Flisom AG
8155 Niederhasli (CH)**

(72) Inventors:
• **Torres-Sevilla, Galo
8600 Dübendorf (CH)**
• **Romanyuk, Yaroslav E.
8117 Fällanden (CH)**
• **Tiwari, Ayodhya N.
8706 Meilen (CH)**
• **Löckinger, Johannes
8103 Unterengstringen (CH)**
• **Perrenoud, Julian
5707 Seengen (CH)**

(74) Representative: **Keller Schneider
Patent- und Markenanwälte AG (Zürich)
Beethovenstrasse 49
Postfach
8027 Zürich (CH)**

(54)  **THIN FILM SOLAR CELL STACKS AND OPTIMIZATION METHOD THEREOF**

(57)     A method for treatment of thin film solar modules (1) or solar cell stacks (2), comprising at least one semiconducting light absorbing layer (21) and a semiconducting buffer layer (22), which are spaced apart in direction of the longitudinal axis (L) and extended in the transverse direction (Q) with a defined width, is sought, which increases the parallel resistance and conversion efficiency of each treated solar cell stack (2). This is reached by a reduction step (I), applied to the side faces (11) of the thin film solar cell stacks (2), which extend in a plane, whose normal vector (N) is perpendicular to the longitudinal axis (L) performed in a reduction environment comprising an atmosphere of organo-metal compounds with alkane, alkene, alkyne groups and its derivatives or active hydrogen comprising compounds, like Hydrogen chalcogenides or amine group compounds including primary, secondary, tertiary amine.

FIG. 1

**Description**

**TECHNICAL FIELD**

The present invention describes a method for treatment of thin film solar modules or solar cell stacks, comprising a lower electrode layer, at least one semiconductor comprising light absorbing layer and a semiconductor comprising window layer, which are layered in direction of the longitudinal axis and extended in the transverse direction with a defined width, to increase the parallel resistance and conversion efficiency of each treated solar cell stack or solar module, and thin film solar cell stack optimized by the method.

**STATE OF THE ART**

Chalcogenide thin film solar modules are very promising and especially so called CIGS solar modules based on Cu(In,Ga)Se2, [$CuIn_xGa_{(1-x)}Se_2$] x=0 to 1], build of CIGS solar cells. CIGS layers are thin enough to be flexible, allowing them to be deposited on flexible substrates. CIGS cells and modules continue being developed, as they promise to reach silicon-like efficiencies, while maintaining their low costs, as is typical for thin-film technology.

Known CIGS solar cells for such modules can be produced for example by the following method steps:

(a) forming a lower electrode layer on a substrate;
(b) forming a CIGS light absorbing layer on the lower electrode layer by supplying a copper precursor to deposit a copper thin film using physical vapor deposition and then supplying a gallium precursor, an indium precursor, and a first selenium precursor to deposit a gallium thin film and an indium-selenium thin film using physical vapor deposition (PVD); and
(c) sequentially forming a buffer layer and a front electrode layer on the CIGS light absorbing layer.

Such CIGS solar cells are building stacks of different layers, just like the other known solar cells, based on Cadmium telluride or kesterite.

After the known production, such non-encapsulated CIGS solar cells and modules are having problems with long-term stability of parallel resistance (shunt) or series resistance. To improve these disadvantages, a passivation layer was arranged on a module, after building the solar cell stacks, building a protective layer.

Al2O3 is known as a passivation layer for several photovoltaic technologies due to its stability and ease of deposition. Several publications describe the use of this material for CIGS solar cells, for example US 2016/0064591.

The Al2O3 passivation is done on rear surface and front surface of the solar cell stacks at temperatures of 250 C. as explained in Hsu, W-W., et al. "Surface passivation of Cu (In, Ga) Se2 using atomic layer deposited Al2O3." Applied Physics Letters 100.2 (2012): 023508.

Other options such as the use of expensive front sheets are also widely available in the solar cell industry, to protect cell and module surfaces. Most of the current reasearch in this topic is mainly focused on laboratory-scale solar cells and not on solar modules for industrial scale and these efforts so far did not lead to solar cell stacks or solar cell modules with increased efficiencies and a long term stability of the conversion efficiency.

**DESCRIPTION OF THE INVENTION**

The object of the present invention is to boost efficiency of thin film solar cell stacks and thin film solar cell modules. The resulting improved efficiency should be maintained as long as possible, while degradation of existing thin film solar cell stacks and modules after their production should be stopped.

As could be seen, the here described method can be applied to CIGS solar cells/modules or thin film Cadmium telluride solar cell/modules or so called kesterite solar cells/modules of kesterite, the natural sulfide mineral ($Cu_2(Zn,Fe)SnS_4$) or to perovskite-based solar cells/modules.

In the field of industrially available solar cell modules, the performance improvement of module efficiency is the main focus of the present invention.

Furthermore, our method can also help reduce the overall cost of the solar module by eliminating or reducing the need for expensive front protective sheets, which in CIGS technology corresponds to at least 30% of the terminated module cost, up to now.

**BRIEF DESCRIPTION OF THE DRAWINGS**

Further understanding of various aspects of the invention can be obtained by reference to the following detailed description in conjunction with the associated drawings, which are described briefly below.

Figure 1     shows a schematic cross section of a CIGS-solar module based on two solar cell stacks to which a reduction step is applied.

Figures 2    are showing a comparison in performance and stability between solar cell stacks after treatment of a reduction step and a material deposition step and without any treatment after production of such solar cells.

Figures 3    are showing graphs of three different experiments, without reduction step, with reduction step and with additional deposition step, showing effects of the reducing environment in CIGS modules in efficiency and fill factor.

## DESCRIPTION

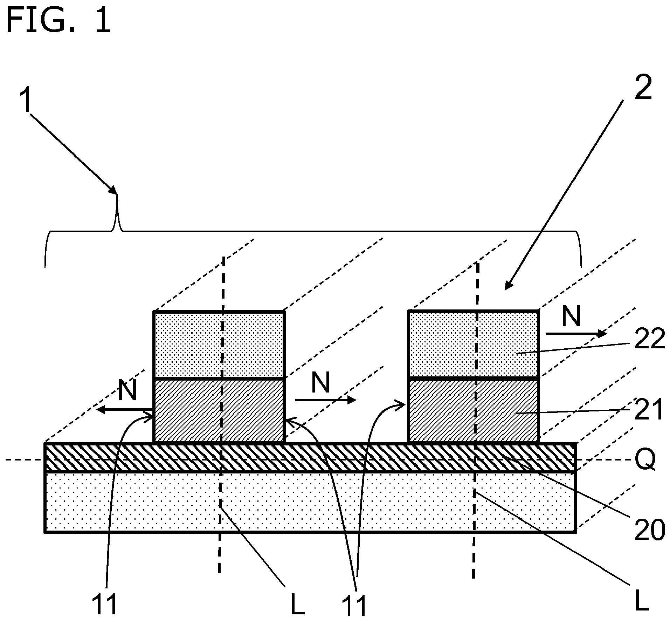

A thin film solar module 1, as an example a CIGS solar module 1, comprising a multiplicity of CIGS solar cells 2 in form of single solar cell stacks 2, which are spaced apart in one plane, is shown. The presented method was performed successfully on such CIGS solar modules 1. Each CIGS solar cell stack 2 is comprising typical and known layers 20 to 22, as depicted in Figure 1.

In direction of a longitudinal axis L a substrate layer, is indicated by the dotted area at the bottom. A lower electrode layer 20 is typically made of a Molybdenum layer 20. A light absorbing layer 21 is made of a CIGS-layer 21 in CIGS solar cell stacks 2. Subsequently a window layer 22, a combination of at least partly semiconducting layer, for example a CdS-layer, and a front electrode layer, for example a transparent conductive oxide (TCO) layer are deposited in a layered way in direction of the longitudinal axis L of the solar cell stack 2. The layers 20, 21, 22 are distinguishable and directly or indirectly adjacent in direction of the longitudinal axis L and extended in a transverse direction Q over at least a part of the width of the solar cell stack 2 respectively over at least a part of the width of solar module 1. The longitudinal axis L is normally defined in the centre of the solar cell stack 2.

The manufacturing of such solar cell stacks 2 and/or the arrangement of a multiplicity of such solar cell stacks 2 forming a solar module 1 are done in a conventionally known way.

After production of the solar cell stack 2 or a multiplicity of solar cell stacks 2 in solar modules 1, our method is applied, which is new based on a reduction step I.

After the at least one reduction step I at least one deposition step II for environmental protection can be carried out, while both steps also can be performed on solar cells of related photovoltaic technologies, e.g. CdTe, kesterite, perovskite modules, after their production.

### The reduction step I

The reduction step I is performed by placing for example the CIGS thin film solar cells or modules in a reducing environment and applying a reduction to the side faces 11 of the layers of each solar cell stack 2. The side faces 11 are extending in a plane, whose normal vector N is perpendicular to the longitudinal axis L, while the side faces 11 are spaced apart from the longitudinal axis L. The side faces 11 are stretched parallel to the longitudinal axis L and parallel or perpendicular to a transverse direction Q of the solar cell stack 2.

The reduction step I can be performed with reducing precursors based on organo-metal compounds with at least one metal ion with alkyl or amine or carboxylates or aromatic ligands groups, in particular for example trimethylaluminum (TMA) or diethylzinc (DEZ).

Also educing atmospheres comprising active hydrogen comprising compounds, like Hydrogen chalcogenides (H2S, H2Se, etc) can be used.

Different amine group compounds including primary, secondary, tertiary amine, are candidates as reduction chemicals, for example: methylamine (MeNH2), ethylamine (EtNH2), etc.

The here depicted results were accomplished by using reducing atmospheres of trimethylaluminium (TMA) and bis(ethylcyclopentadienyl)magnesium $(Mg(CpEt)_2)$.

The reduction step I is performed in a temperature range between 15°C and 250 °C.

The reduction step I is performed for an application time of at least 1 second.

While the reduction step I, the partial pressure regime of the reduction atmosphere chemicals lies between 0.1 Pascal and 100000 Pascal. The reduction step I can be carried out in a glovebox under use of inert gas or in a vacuum chamber as reduction chamber.

The bare semiconducting surfaces or surfaces of the CIGS-layer side faces 11, extending in a plane perpendicular to the longitudinal axis L, are treated, while the reduction step I is performed in a reducing environment with different chemicals, under certain pressures and temperatures and for defined periods of time.

The reduction step I leads to a change of the surface of the side faces 11 of the semiconductor layer in order to reduce carrier recombination velocity and improved back reflection of electrons into the bulk. Even if the front side and/or back side face surfaces would change their appearance or shape, this has no effect on the later efficiency or parallel resistance.

The reduction step I increases the absolute power conversion efficiency (PCE) and parallel resistance of the prepared solar cells and modules, as could be confirmed by experiments.

Increase in parallel resistance (Rp), can be seen as the main effect of the reducing environment. Rp directly affects the Fill Factor (FF%) of the solar module. And FF% is directly proportional to the efficiency of the module as can be seen in the following equation:

$$\eta = \frac{V_{OC}I_{SC}FF}{P_{in}}$$

Where n is the efficiency, Voc is the open circuit voltage, Isc is the short circuit current, and FF is the fill factor of the module. Pin describes the input power.

### Deposition step II

Subsequently, further steps, for example the at least one deposition step II should be carried out, which further increases long-term stability. The deposition step II can be performed timely directly after the reduction step I and is known from the prior art.

Here the deposition step II is performed with Atomic Layer Deposition (ALD) at 150 °C in an ALD chamber at a base pressure of 13.3 Pascal. At least one atomic layer of aluminum oxide (Al2O3) was deposited, that reduces parasitic shunt paths for monolithically-interconnected CIGS modules and improves the long-term stability of the CIGS solar cells or modules.

The deposition step II can also be performed with any electrically insulating layer that can be experimentally deposited and would hinder or prevent re-oxidation of the surface, for example oxides of Mg, Al, Si, Sn, Zn, in particular MgO, Al2O3, SiO2, SnO2, ZnO, Zn-MgO, among others.

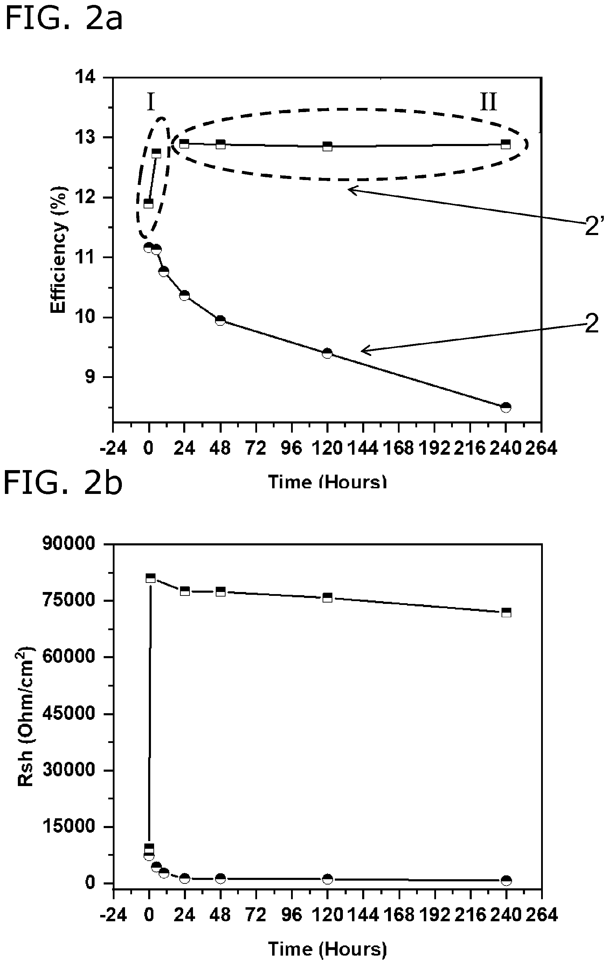

Deposition step II can take from 30 seconds to several hours depending on the required thickness. An immediate gain in parallel resistance and its direct influence in the module efficiency can be seen after deposition, as depicted in Figure 2b. Furthermore, environmental stability of the module can clearly be seen when compared to non-coated modules.

After performance of reduction step I a direct deposition of a protective layer on the finalized CIGS solar cell stack 2 or module 1 is reached. With the deposition step II, the thin film solar cell stacks 2 and/or the solar modules 1 are completely covered with a deposition layer, while performing the deposition step II.

The deposition step II can also be performed by depositing a polymer onto the front surface of the solar cell module, comprising a multiplicity of solar cells after passing through the at least one reduction step I. This step is defined as lamination step.

Figure 2a shows the conversion efficiency versus time for an untreated bare solar cell stack 2 and a second solar cell stack 2', on which both process steps, the reduction step I and the deposition step II, were applied.

In the not treated sample 2, the conversion efficiency decreases from above 11% to below 9% in 240 hours. The two step treatment of the second sample 2' can be recognized in the diagram, which is indicated by I, II. The reduction step I leads to a first efficiency rise to about 13%, which could be kept during the entire measurement period.

Because of the positive correlation between parallel resistance and efficiency of the solar cell stack, Figure 2b shows the same dependency. The untreated sample solar cell shows a very small increase of the parallel resistance and a fast decay. The second sample cell shows a strong increase of the parallel resistance after reduction step I and a stabilized very slow decrease of the parallel resistance after the deposition step II.

Other solar modules 1 tested immediately reduction step I and deposition step II showed no degradation after 3 months of exposure to air, while the reference modules without treatment exhibit an exponential degradation of parallel resistance with a loss of 50% of the initial value after 1 to 5 days of air exposure depending on the ambient temperature.

Due to the advances in thin film technologies and constantly improved equipment, this reduction technique proves to be industrially scalable and directly applicable to large-scale production of solar modules.

The reduction step II as disclosed above can also be successfully applied to other known solar cells, based on Cadmium telluride, kesterite.

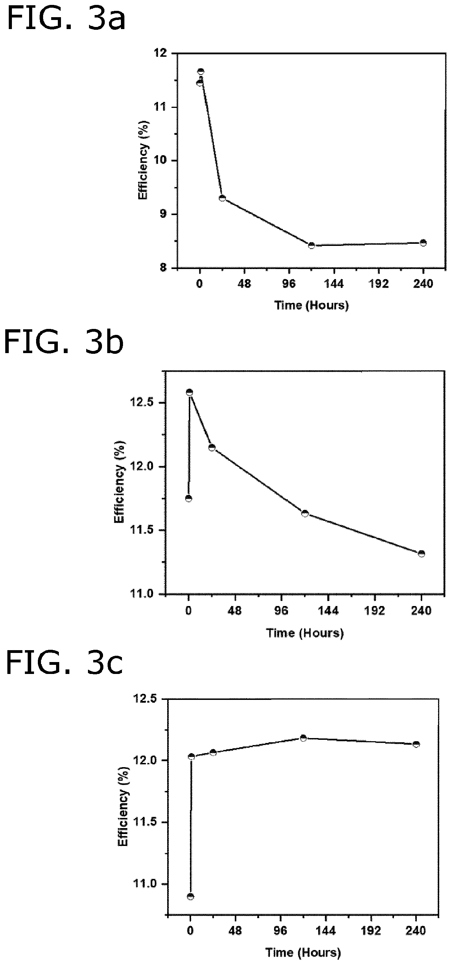

Figure 3a shows the efficiency versus time of a produced and annealed thin film solar CIGS-module 1, without any further treatment. Since no reducing agent is introduced, no effect is seen in the sample in terms of improved efficiency.

Figure 3b shows the efficiency versus time of a produced thin film solar CIGS-module 1, after a reduction step I, wherein TMA was introduced as a reducing agent. A clear increase in efficiency can be seen. However, since no protection layer is deposited, efficiency gain is lost over time.

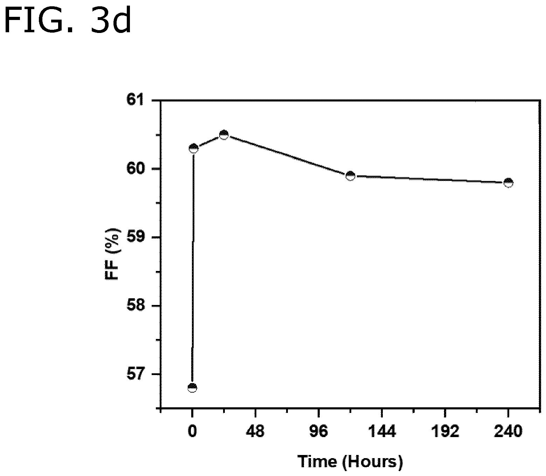

A produced thin film solar CIGS-module 1 after a reduction step I with TMA as reducing agent and a deposition step II based on deposition of Al2O3, leads to an increase of the efficiency, which remains over a long period of time. This is depicted in Figure 3c. Figure 3d shows the timely development of the fill factor of the thin film solar CIGS-module 1 after reduction step I and deposition step II.

Optionally, for all embodiments the reduction step I could be further improved by masking the side faces 11 of the solar cell stacks 2 before placement of the solar cell stack 2 or solar module 1 in the described reduction environment.

## LIST OF REFERENCE NUMERALS

1 thin film solar module (CIGS-module)
11 side faces of the semiconducting layers
2 thin film solar cell stack
20 lower electrode layer / back contact / Mo-layer
21 light absorbing layer /(CIGS-layer (p-type))
22 window layer /(mix of semiconductor and front electrode layer L longitudinal axis
Q transverse direction
N normal vector of plane of side faces 11
I reduction step / introducing in reducing environment
II environmental protection step / deposition

## Claims

1. Method for treatment of thin film solar modules (1) or solar cell stacks (2), comprising a lower electrode layer (20), at least one semiconductor comprising light absorbing layer (21) and a semiconductor comprising window layer (22), which are layered in direction of the longitudinal axis (L) and extended in the transverse direction (Q) with a defined width, to increase the parallel resistance and conversion efficiency of each treated solar cell stack (2) or solar module (1),

**characterized in that**

after production of the solar cell stacks (2) with bare semiconducting layers (21, 22)

a reduction step (I) is applied to the side faces (11) of the thin film solar cell stacks (2), which extend in a plane, whose normal vector (N) is perpendicular to the longitudinal axis (L), performed in a reduction environment comprising an atmosphere of organo-metal compounds,

with at least one metal ion with

alkyl or amine or carboxylates or aromatic ligands groups, wherein in particular alkane, alkene, alkyne and its derivatives, and/or active hydrogen comprising compounds, like Hydrogen chalcogenides and/or amine group compounds including primary, secondary, tertiary amine are used.

2. Method for treatment of thin film solar modules (1) or solar cell stacks (2) according to claim 1, wherein the reduction step (I) is performed with trimethylaluminium (TMA) or bis(ethylcyclopentadienyl)magnesium (Mg(CpEt)$_2$).

3. Method for treatment of thin film solar modules (1) or solar cell stacks (2) according to one of the preceding claims, wherein the partial pressure of the reduction chemicals lies between 0.1 Pascal and 100000 Pascal.

4. Method for treatment of thin film solar modules (1) or solar cell stacks (2) according to one of the preceding claims, wherein the reduction step (I) is performed in a temperature range between 15°C and 250°C.

5. Method for treatment of thin film solar modules (1) or solar cell stacks (2) according to one of the preceding claims, wherein the reduction step (I) is performed for an application time of at least one second.

6. Method for treatment of thin film solar modules (1) or solar cell stacks (2) according to one of the preceding claims, wherein timely directly after the reduction step (I), at least one deposition step (II) is performed subsequently.

7. Method for treatment of thin film solar modules (1) or solar cell stacks (2) according to claim 6, wherein the deposition step (II) is performed with any electrically insulating layer that can be experimentally deposited, for example MgO, Al$_2$O$_3$, SiO2, SnO2, ZnO or ZnMgO.

8. Method for treatment of thin film solar modules (1) or solar cell stacks (2) according to one of the preceding claims, wherein at least one deposition step (II) is performed by chemical vapour deposition or atomic layer deposition (ALD) at temperatures between 15 °C and 250 °C.

9. Method for treatment of thin film solar modules (1) or solar cell stacks (2) according to one of the preceding claims, wherein each thin film solar cell stack (2) or the completed thin film solar module (1) is placed in a reduction chamber, before the reduction step (I) is applied.

10. Method for treatment of thin film solar modules (1) or solar cell stacks (2) according to one of the preceding claims, wherein the deposition step (II) is performed in the same chamber in which the reduction step (I) is carried out.

11. Method for treatment of thin film solar modules (1) or solar cell stacks (2) according to one of the preceding claims, wherein the reduction step (I) is carried out in a glovebox under use of inert gas or in a vacuum chamber as reduction chamber.

12. Thin film solar cell stack (2) optimized by a method according to one of the preceding claims, wherein the side faces (11) of the semiconductor comprising layers (21, 22) are treated with the method according to one of the preceding claims.

FIG. 1

## FIG. 2a

## FIG. 2b

## FIG. 3a

## FIG. 3b

## FIG. 3c

# FIG. 3d

Europäisches
Patentamt

European
Patent Office

Office européen
des brevets

# EUROPEAN SEARCH REPORT

Application Number

EP 19 20 8081

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 579 325 A1 (KYOCERA CORP [JP]) 10 April 2013 (2013-04-10) | 1-12 | INV. H01L31/032 |
| Y | * abstract; figures 1,2 * * paragraphs [0008], [0010] - [0011], [0018], [0041], [0047], [0053] * ----- | 1-11 | H01L21/02 H01L31/0749 H01L31/18 H01L31/0296 |
| X | WO 2018/156698 A1 (FIRST SOLAR INC [US]) 30 August 2018 (2018-08-30) | 12 | |
| Y | * abstract * * paragraphs [0032], [0051] - [0052], [0057] - [0063]; claims 2, 5-6 * ----- | 1-11 | |

TECHNICAL FIELDS
SEARCHED      (IPC)

H01L

The present search report has been drawn up for all claims

| Place of search | Date of completion of the search | Examiner |
|---|---|---|
| Berlin | 20 February 2020 | Cichos, Anna |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

                                                        
& : member of the same patent family, corresponding
   document

EPO FORM 1503 03.82 (P04C01)

**EP 3 819 946 A1**

## ANNEX TO THE EUROPEAN SEARCH REPORT
## ON EUROPEAN PATENT APPLICATION NO.

EP 19 20 8081

This annex lists the patent family members relating to the patent documents cited in the above-mentioned European search report.
The members are as contained in the European Patent Office EDP file on
The European Patent Office is in no way liable for these particulars which are merely given for the purpose of information.

20-02-2020

| Patent document cited in search report | | Publication date | Patent family member(s) | | Publication date |
|---|---|---|---|---|---|
| EP 2579325 | A1 | 10-04-2013 | CN | 102870224 A | 09-01-2013 |
| | | | EP | 2579325 A1 | 10-04-2013 |
| | | | JP | 5430758 B2 | 05-03-2014 |
| | | | JP | WO2011152334 A1 | 01-08-2013 |
| | | | US | 2013069187 A1 | 21-03-2013 |
| | | | WO | 2011152334 A1 | 08-12-2011 |
| WO 2018156698 | A1 | 30-08-2018 | AU | 2018225659 A1 | 19-09-2019 |
| | | | CN | 110546769 A | 06-12-2019 |
| | | | EP | 3586374 A1 | 01-01-2020 |
| | | | WO | 2018156698 A1 | 30-08-2018 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160064591 A

**Non-patent literature cited in the description**

- **HSU, W-W. et al.** Surface passivation of Cu (In, Ga) Se2 using atomic layer deposited Al2O3. *Applied Physics Letters,* 2012, vol. 100.2, 023508